Europäisches Patentamt

(19) European Patent Office

Office européen des brevets

(11) Publication number: **0 088 557**
**B1**

(12) **EUROPEAN PATENT SPECIFICATION**

(45) Date of publication of patent specification: **13.06.90**

(51) Int. Cl.⁵: **H 01 L 23/29**

(21) Application number: **83300956.6**

(22) Date of filing: **23.02.83**

(60) Divisional application **89202084.3** filed on **23/02/83.**

(54) **Resin encapsulated semiconductor device.**

(30) Priority: **10.03.82 JP 36468/82**

(43) Date of publication of application:
**14.09.83 Bulletin 83/37**

(45) Publication of the grant of the patent:
**13.06.90 Bulletin 90/24**

(84) Designated Contracting States:
**DE FR GB NL**

(56) References cited:
**EP-A-0 043 692**
**CH-A- 621 667**
**GB-A-2 055 508**
**US-A-3 838 240**
**US-A-3 975 757**
**US-A-4 213 556**

**PATENT ABSTRACTS OF JAPAN, vol. 6, no.
72(E-105)(950), 7th May 1982 & JP-A-57-12531**

(73) Proprietor: **Hitachi, Ltd.**
**5-1, Marunouchi 1-chome**
**Chiyoda-ku Tokyo 100 (JP)**

(72) Inventor: **Onuki, Jin**
**1-6-1 Kuji-cho**
**Hitachi-shi Ibaraki-ken (JP)**
Inventor: **Suwa, Masateru**
**1220-191 Muramatsu**
**Toukai-mura Naka-gun Ibaraki-ken (JP)**
Inventor: **Koizumi, Masahiro**
**161-512, Ishinazaka-cho**
**Hitachi-shi Ibaraki-ken (JP)**
Inventor: **Iizuka, Tomio**
**1307 Midoirgaoka-danchi**
**Toukai-mura Naka-gun Ibaraki-ken (JP)**
Inventor: **Tamamura, Takeo**
**2-16-18 Nishinarusawa-cho**
**Hitachi-shi Ibaraki-ken (JP)**

(74) Representative: **Paget, Hugh Charles Edward
et al**
**MEWBURN ELLIS & CO. 2/3 Cursitor Street**
**London EC4A 1BQ (GB)**

**Description**

The present invention relates to a method of manufacture of a resin encapsulated semiconductor device.

In resin encapsulated semiconductor devices (such as an IC, LSI or transistor), Au wire of diameter of 20 ~ 50 µm is generally employed for the electrical connection between the semiconductor element and the external lead frame of the package. To bond the wire to the semiconductor element, there are two methods, wedge bonding and ball bonding. In these bonding methods, one end of the Au wire, or a ball formed at the end of the Au wire through fusion thereof by means of a discharge or hydrogen flame, is bonded to the semiconductor element directly or through a deposited metallic film by thermo-compression bonding or ultrasonic bonding. The connection of the other end of the wire to the lead frame is effected by wedge bonding using a capillary tube.

The use of Al wire instead of Au wire has been studied, since Au wire is expensive. For Al wire, wedge bonding by means of thermo-compression bonding or ultrasonic bonding has also been investigated. However conventional Al wire, when used as it has been drawn, retains a hardness caused by the drawing. The present inventors have found that in both thermo-compression bonding and ultrasonic bonding of Al wire, the part of the wire near the bonded portion is softened by heating, so that a local deformation takes place at the bonding portions in the connection of the wire from the semiconductor element to the lead frame, and that such a local deformation not only causes the wire to be locally reduced in diameter but also may result in breakage or the like.

Moreover, the present inventors have discovered, as the result of examination of ball bonding of Al wire, that since conventional Al wire is wound on a reel as it has been drawn, the wire is elastically bent when a ball is formed at its end and the ball is eccentrically formed. Furthermore, since when the ball is formed not only the end but also the vicinity of the end is heated, the portion of the wire directly above the ball is subjected to annealing and, consequently becomes softened or locally constricted.

The inventors have also found that the eccentricity of the ball may cause the bonding portion to project from a pad, bringing about a short-circuit with another bonding portion, or damage to the circuit.

Furthermore, the inventors have discovered that if a constriction is produced directly above the ball or if the wire softens, since the portion not annealed remains work-hardened, the residual work set of the wire prevents the wire and the bonding portion from occupying a fine curve, so that the wire is bonded in a bent shape, which may cause breakage of the wire, particularly in a dual in-line type IC and LSI having a difference in level between the bonding surfaces of the semi-conductor element and the lead frame. This may cause a short-circuit between the wire and the semiconductor element.

In resin encapsulated semiconductor devices a larger mechanical stress is applied to the wire because it is rigidly molded with thermosetting resins such as epoxy resins, phenol resins, polyester resins, etc. The mechanical stress is maximum at the bonding position on the semiconductor chip. Thus, it has now been found that in resin encapsulated semiconductor devices the nature of the wire materials play a very important role in the production of a satisfactory ball bonding connection.

It is an object of the present invention to provide a method of manufacture of a resin encapsulated semiconductor device containing an electrical connection with a wire which permits good connections to be formed and with which there is a low risk of breakage of the wire.

The present invention is set out in claim 1.

Devices of the prior art and embodiments of the present invention will now be described by way of example with reference to the accompanying drawings, in which:

Fig. 1 is a sectional wire of a semiconductor device with a wire having a wedge-bonded connection at both ends;

Fig. 2 is a sectional view of a semiconductor device with a wire having a ball-bonded connection at one end and a wedge-bonded connection at the other end;

Fig. 3(a) is a sectional view indicating a further step following Fig. 2 in wedge-bonding;

Fig. 3(b) is a sectional view showing how a ball is formed by discharge;

Fig. 4 is a sectional view of a resin molded type semiconductor device embodying the present invention; and

Fig. 5 is a bar graph showing the relationship between conventional wires and wires used in the present invention, on the one hand, and the percentage of production of eccentricity and the percentage of production of eccentricity and constriction, on the other hand.

Since a wire made of a metal having in the annealed state an elongation at room temperature of not more than 60% is very highly work-hardened in the worked state (i.e. after the wire has been worked), it is difficult to destroy the oxide film formed on the surface of the ball in thermo-compression bonding or ultrasonic bonding, so that bonding is difficult. Moreover, since the vicinity of the bonding portion is softened by heating during bonding as described above, the local deformation is especially large. It has now been discovered that it is necessary to anneal the wire made of a metal having such an elongation so that it becomes softer. Annealing permits the wire to be softened throughout, so that there is no possibility of local deformation, and consequently, problems such as disconnection are solved.

It is preferable to employ a wire having a specific resistance at room temperature (20°C) of not more than 150 $\mu\Omega$cm.

The bonding process may for example be either a ball bonding or wedge bonding procedure and can be effected by ultrasonic bonding or thermocompression bonding. Ball bonding is preferable and generally more effective in the case of a semiconductor element which is a circuit element, because bonding distance is limited and the necessity to turn the semiconductor device is avoided. On the other hand, where there is an external terminal, wedge bonding is preferable and can achieve high efficiency.

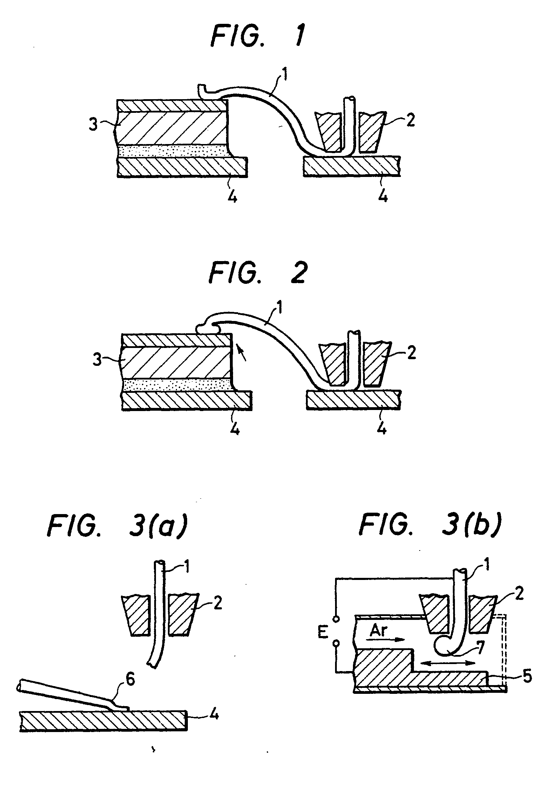

Figs. 1, 2 and 3(a) illustrate wedgebonding. A wire 1 emerges from a capillary feeder 2, the bottom end of which is used to effect the wedgebonding, as Figs. 1 and 2 show. After the bonding step, the capillary 2 is removed to break the wire, leaving a bonded portion 6 attached to the Cu lead frame 4. The lead frame may alternatively be a Fe-Ni alloy. Fig. 1 shows the other end of the wire 1 wedge-bonded to a metal layer on the top of the semiconductor element 3, which is itself mounted on another part of the lead frame 4.

Fig. 2 shows a ball-bonded connection of the wire 1 at the top surface of the semiconductor element 3. Fig. 3(b) shows how, in ball-bonding, the ball 7 is formed using the surface tension of the wire itself by fusing the end of the wire held by a capillary 2 by means of discharge, hydrogen flame, plasma, arc, a laser beam or the like. Particularly preferred, as illustrated in Fig. 3(b) is arc discharge between the wire istelf and a separate electrode 5. The arc discharge is performed with the wire at minus polarity, whereby a clean ball having no oxide film on its surface is formed. In addition, it is possible to supply a pulse current of at least one of positive and negative in the arc discharge. The pulse current permits control of the correct arc-generating time necessary for formation of a ball. When supplying a current of positive and negative, control can be effected by converting the time required for cleaning and the time required for formation of a ball into a time ratio between positive and negative. The time required for cleaning accounts for about 10 ~ 30% of the discharge time).

It is preferable that the heating-fusing atmosphere in ball formation is a non-oxidising atmosphere. Particularly preferred is an inert gas including a small amount, preferably 5 ~ 15 vol.% of a reducing gas (e.g. hydrogen gas). The inclusion of such a reducing gas is preferable for a metal having a high affinity to oxygen, such as Al, Ti, Nb, Zr or the like. Especially, for Al it is preferable to employ an atmosphere including 5 ~ 15 vol.% hydrogen gas.

Fig. 3(b) shows how the ball 7 may be eccentrically formed.

Although any ball diameter is in principle useful, preferred are diameters 1.5 ~ 4 times, particularly 2.5 ~ 3.5 times, as large as the wire diameter.

The wire diameter range used in the invention is 20 ~ 100 µm, although this varies according to the kind of metal. For example, the Al wire diameter may be about 50 µm, while the Cu wire diameter may be about 30 µm. The wire diameter is selected in relation to the specific resistance.

The annealing temperature is higher than the recrystallization temperature of the metal, although it differs according to the kind of metal. It is particularly preferred to employ a temperature at which the wire is substantially full-annealed to an extent that it is not elastically deformed i.e contains substantially no elastic deformation. It is preferable that the wire is softened so as to have the same hardness throughout, since if the wire locally has a difference in hardness, a local deformation is produced, as described above. For example, preferable annealing temperatures are 150 ~ 400°C for Al, 400 ~ 600°C for Cu, 650 ~ 800°C for Ni, 250 ~ 400°C for Ag, 400 ~ 1100°C for Ti, 1000 ~ 1100°C for Mo, and 800 ~ 1000°C for Pd and Pt.

Although it is possible to anneal a wire which has already been bonded to a circuit element in its worked state, it is far more efficient to bond a wire previously annealed, as required by the present invention.

The wire, after being bonded to a circuit element, may be cut in the vicinity of the bonded portion of the circuit element by holding the wire in a capillary and pulling it (Fig. 3(a)). It may be difficult to cut the wire in the vicinity of the circuit element, since the wire itself is soft throughout, in which case it is preferable to cut the wire with a cutter.

Since the wire usually has an extremely small diameter, and is soft as described above, the semiconductor element, the wire and a part of the external terminal or lead frame are covered with resin in order to protect the wire. Typically, liquid resin is cast or molded and then hardened.

### Example

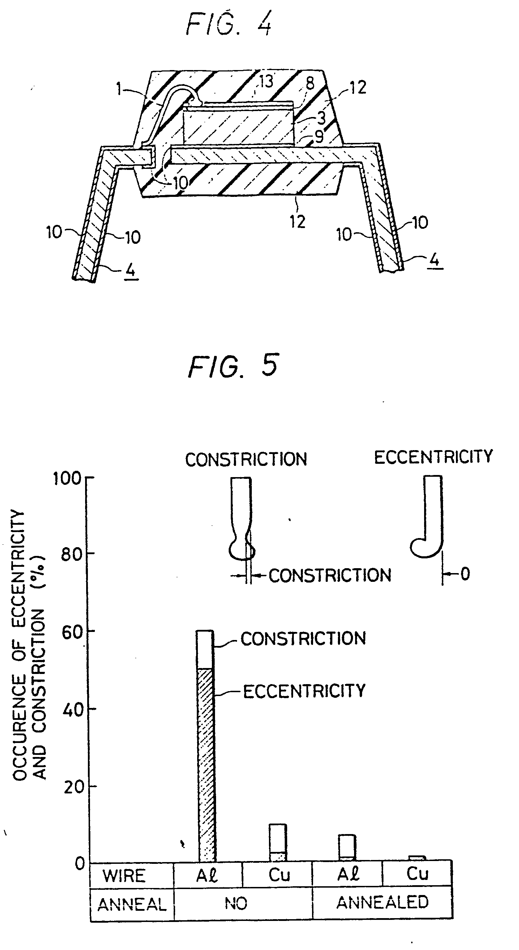

Fig. 4 is a sectional view of a resin-encapsulated type semiconductor device according to the present invention having an annealed Al wire 1. The Al wire is previously subjected, prior to bonding, to a full annealing of 1-hour heating at 250°C in $N_2$ gas. The Al wire 1 is then ball-bonded to the semiconductor element 3 which is provided with an Al deposited film 8, while the wire 1 is wedge-bonded to the lead frame 4 which is provided with an Ag or Ni deposited layer 10. After the ball bonding, a protective film 13 such as $SiO_2$ or the like is provided on the layer 8. Then, a thermosetting resin composition 12 is transfermolded to form the semiconductor device shown in Fig. 4. A low-melting glass 9 may be used to mount the semiconductor element 3.

During the bonding, the Al wire is extruded through a capillary 2 as shown in Figs. 3(a) and 3(b). Al wire described above was subjected to discharge under discharge conditions of 1,000V and 10 ~ 20 mA in the atmosphere replaced, after evacuation, with an Ar gas atmosphere including 7% (volume) hydrogen, in order to form a ball at its end. The discharge was effected by moving a separately provided W electrode 5 relatively to the wire. The time for ball formation was controlled by the speed of movement of the electrode and a correctly determined frequency of pulsed energization. Moreover, the energization was performed by means of a pulse current of positive and negative, with the energisation made less on the side of cleaning the wire. The ball obtained was ultrasonically bonded to the semiconductor element by means of the capillary 2, and then the other end was similarly ultrasonically bonded to the lead frame 4.

Although the ball obtained by this method had the shape of an oval slightly longer in the axial direction of the wire, it was close to an excellent sphere. It has been confirmed that the ball is substantially equal in hardness to the wire itself, and it is possible to achieve a good loop-shaped connection wire without any local deformation in the vicinity of the ball, as shown in Fig. 4. In addition, although the cutting of the wire after wedge bonding is effected by lifting the capillary in order to pull the wire, the cutting was extremely easy because the wire was soft, and moreover the pulling did not cause any problems such as exfoliation of the bonding portion.

Since the illustrated semiconductor device embodying the present invention has no local deformation of the wire in ball bonding and consequently a desired loop shape can be obtained, there is a minimal possibility of disconnection due to local deformation and moreover, there was no defect such as short-circuit of the wire with the element.

Production of balls at wire ends for bonding A ball was formed by the method of Fig. 3(b) at the end of each of a Cu wire having a diameter of 30 μm an remaining as it has been worked, and a wire obtained by subjecting such a wire to a full annealing of 1-hour heating at 400°C in Ar gas.

The discharge was effected under a voltage of 1000V, a current of 10 ~ 20 mA and in Ar gas. The discharge time was controlled by the speed of movement of the W electrode 5 and the pulse frequency, as described above.

In a similar manner to the above, a ball was formed at the end of each of an Al wire having a diameter of 50 μm and remaining as it has been worked and a wire obtained by subjecting such an Al wire to a full annealing of 1-hour heating at 250°C. The discharge conditions were substantially the same as for the Cu wires, except that the discharge current was 1 to 10 mA.

For each of these types of Cu and Al wires, 50 balls were formed, and the number of the balls having constrictions and eccentricity was examined and the then the percentage thereof was obtained. The results are shown in Fig. 5.

Fig. 5 shows that the Al wire remaining as it has been worked exhibits a constriction level of 60% and eccentricity level of 50%, while the annealed Al wire exhibits a constriction level of only 7% and an eccentricity level of the order of a few %. It forms a round ball symmetrical with respect to the wire axis. Moreover, although the Cu wire is better than the Al wire even when the Cu wire remains as it has been worked, the annealed Cu wire exhibits hardly any constriction and eccentricity.

Thus, by the present invention, it is possible to obtain a wire connection having no local deformation at the bonding portion of the wire.

## Claims

1. A method of manufacture of a resin encapsulated semiconductor device which comprises at least one semiconductor element (3) electrically connected to a lead frame (4) by a metal wire (1) having a diameter of 20 to 100 μm by bonding, wherein a ball (7) formed at one end of said metal wire (1) is bonded to said semiconductor element (3), and the other end of said metal wire (1) is bonded to said lead frame (4) and, after the bonding of said metal wire (1) to said semiconductor element (3) and said lead frame (4), said semiconductor element (3), said metal wire (1) and at least part of said lead frame (4) are encapsulated by a thermosetting resin (12), characterized in that said metal wire (1) is an Al wire or a Cu wire and is annealed, before the bonding to said semiconductor element (3) and said lead frame (4), at a temperature higher than the recrystallization temperature of the metal material, and in that said metal wire (1) exhibits in an annealed state a maximum elongation of not more than 60% at room temperature (20°C).

2. A method according to claim 1 wherein said metal wire (1) is ball-bonded to an Al thin film (8) formed on said semiconductor element (3) while the other end of said metal wire (1) is wedge-bonded to a surface of said lead frame (4).

3. A method according to claim 1 wherein said metal wire (1) is ball-bonded to an Al thin film (8) formed on said semiconductor element (3) while the other end of said metal wire (1) is wedge-bonded to an Ag, Ni or Al thin film (10) formed on a surface of said lead frame (4).

4. A method according to claim 3 wherein said lead frame (4) is made of Cu or a Fe-Ni alloy.

5. A method according to any one of claims 1 to 4 wherein said metal wire (1) exhibits a constriction level and an eccentricity level that are substantially lower than those exhibited by a metal wire that remains in the worked state during the bonding.

6. A method according to any one of claims 1 to 5 wherein after the bonding said metal wire (1) has a specific resistance of not more than 15 μΩ cm at room temperature.

7. A method according to any one of claims 1 to 6 wherein said ball (7) of said metal wire (1) is formed by fusion by means of arc discharge in a non-oxidizing atmosphere containing a reducing gas.

8. A method according to any one of claims 1 to 6 in which the ball (7) is formed by fusion effected by means of arc discharge, hydogen flame, plasma arc or laser beam.

9. A method according to claim 8 wherein the ball (7) is formed by arc discharge, the arc discharge time being controlled by movement of an electrode producing the arc.

10. A method according to claim 8 or claim 9 wherein the ball is formed by arc discharge which is formed by a pulsed current of at least one of positive pulses and negative pulses.

11. A method according to claim 7 wherein the non-oxidizing atmosphere contains 5 to 15 volume % of hydrogen.

12. A method according to any one of the preceding claims where the wire is bonded to said semiconductor element and to said lead frame by ultrasonic bonding.

## Patentansprüche

1. Verfahren zur Herstellung einer in Harz eingekapselten Halbleiteranordnung, die wenigstens ein Halbleiterelement (3) aufweist, das elektrisch durch Bonden mit einem Metalldraht (1) mit einem Durchmesser von 20 bis 100 µm mit einem Anschlußrahmen (4) verbunden ist, wobei eine an einem Ende des Metalldrahtes (1) ausgebildete Kugel (7) mit dem Halbleiterelement (3) verbunden und das andere Ende des Metalldrahtes (1) an dem Anschlußrahmen (4) angebondet wird und wobei nach dem Anbonden des Metalldrahtes (1) am Halbeiterelement (3) und dem Anschlußrahmen (4) das Halbleiterelement (3) der Metalldraht (1) und wenigstens ein Teil des Anschlußrahmens (4) durch ein thermisch aushärtbares Harz (12) verkapselt wird, dadurch gekennzeichnet, daß der Metalldraht (1) ein Al-Draht oder Cu-Draht ist, der vor dem Anbonden am Halbleiterelement (3) und dem Anschlußrahmen (4) bei einer Temperatur ausgeheizt wird, die höher als die Rekristallisationstemperatur des Metall-Materials ist, und daß der Metalldraht (1) im ausgeheizten Zustand bei Raumtemperatur (20°C) eine maximale Dehnung von nicht mehr als 60% zeigt.

2. Verfahren nach Anspruch 1, wobei der Metalldraht (1) an eine dünne Al-Schicht (8), die auf dem Halbleiterelement (3) ausgebildet ist, Nagelkopf-gebondet wird, während das andere Ende des Metalldrahtes (1) an eine Oberlfäche des Anschlußrahmens (4) Keil-gebondet wird.

3. Verfahren nach Anspruch 1, wobei der Metalldraht (1) an eine dünne Al-Schicht (8), die auf dem Halbleiterelement (3) ausgebildet ist, Nagelkopf-gebondet wird, während das andere Ende des Metalldrahtes (1) an eine auf Oberlfäche des Anschlußrahmens (4) ausgebildeten dünnen Ag-, Ni- oder Al- Schicht (10) Keil-gebondet wird.

4. Verfahren nach Anspruch 3, wobei der Anschlußrahmen (4) aus Cu oder einer Fe-Ni-Legierung ist.

5. Verfahren nach einem der Ansprüche 1 bis 4, wobei der Metalldraht (1) einen Einschnürungsgrad und einen Exzentrizitätsgrad zeigt, der jeweils wesentlich kleiner ist als derjenige, den ein Metalldraht hat, der während des Bondens im bearbeiteten Zustand bleibt.

6. Verfahren nach einem der Ansprüche 1 bis 5, wobei der Metalldraht (1) nach dem Bonden bei Raumtemperatur einen spezifischen Widerstand von nicht mehr als 15 µΩcm hat.

7. Verfahren nach einem der Ansprüche 1 bis 6, wobei die Kugel (7) des Metalldrahtes (1) durch Schmelzen mittels einer Bogenentladung in einer nicht-oxidierenden Atmosphäre, die ein reduzierendes Gas enthält, geformt wird.

8. Verfahren nach einem der Ansprüche 1 bis 6, wobei die Kugel (7) durch Schmelzen gebildet wird, die durch eine Bogenentladung, eine Wasserstoff-Flamme, eine Plasmalichtbogen oder einen Laserstrahl bewirkt wird.

9. Verfahren nach Anspruch 8, wobei die Kugel (7) durch eine Bogenentladung gebildet wird, wobei die Entladungszeit durch die Bewegung einer den Bogen erzeugenden Elektrode gesteuert wird.

10. Verfahren nach Anspruch 8 oder Anspruch 9, wobei die Kugel durch eine Bogenentladung gebildet wird, die durch einen pulsierenden Strom mit wenigstens einem positiven Impuls und einem negativen Impuls erzeugt wird.

11. Verfahren nach Anspruch 7, wobei die nichtoxidierende Atmosphäre 5 bis 15 Vol.-% Wasserstoff enthält.

12. Verfahren nach einem der vorstehenden Ansprüche, wobei der Draht durch Ultraschallbonden am Halbleiterelement und am Anschlußrahmen angebondet wird.

## Revendications

1. Procédé pour fabriquer un dispositif à semiconducteurs encapsulé dans un résine, qui comprend au moins un élément semiconducteur (3) raccordé électriquement, par soudage, à un cadre de montage (4) par un fil métallique (1) possédant un diamètre compris entre 20 et 100 µm, et selon lequel on soude un boule (7) formée à une extrémité dudit fil métallique (1) audit élément semiconducteur (3), on soude l'autre extrémité dudit fil métallique (1) audit cadre de montage (4) et, après avoir soudé ledit fil métallique (1) audit élément semiconducteur (3) et audit cadre de montage (4), on encapsule ledit élément semiconducteur (3), ledit fil métallique (1) et au moins une partie dudit cadre de montage (4), dans une résine thermodurcissable (12), caractérisé en ce que ledit fil métallique (1) est un fil de Al ou un fil de Cu et est recuit avant son soudage audit élément semiconducteur (c) et audit cadre de montage (4), à une température supérieure à la température de recristallisation du métal, et en ce que ledit fil métallique (1) présente, à l'état recuit, un allongement maximum non supérieur à 62% à la température ambiante (20°C).

2. Procédé selon la revendication 1, selon lequel on réunit ledit fil métallique (1) par soudage à boule écrasée à une pellicule mince de Al (8) formée sur ledit élément semiconducteur (3), tout en réunissant l'autre extrémité dudit fil métallique (1) par soudage à pincement à une surface dudit cadre de montage (4).

3. Procédé selon la revendication 1, selon lequel on réunit ledit fil métallique (1) par soudage à boule écrasée à une pellicule mince de Al (8) formée sur ledit élément semiconducteur (3), tout en réunissant l'autre extrémité dudit fil métallique (1) par soudage à pincement à une pellicule mince (10) de Ag, Ni ou Al, formée sur une surface dudit cadre de montage (4).

4. Procédé selon la revendication 3, selon lequel ledit cadre de montage (4) est réalisé en un alliage de Cu ou de Fe-Ni.

5. Procédé selon l'une quelconque des revendications 1 à 4, selon lequel fil métallique (1) présente un degré de contraction et un degré d'excentricité, qui sont nettement inférieurs à ceux que présente un fil métallique, qui reste à l'état usiné pendant l'operation de soudage.

6. Procédé selon l'une quelconque des revendications 1 à 5, selon lequel, après l'opération de soudage, ledit fil métallique (1) possède une résistance spécifique non inférieure à 15 μΩ.cm à la température ambiante.

7. Procédé selon l'une quelconque des revendications 1 à 6, selon lequel on forme ladite boule (7) dudit fil métallique (1) par fusion au moyen d'une décharge en arc dans une atmosphère non oxydante contenant un gaz réducteur.

8. Procédé selon l'une quelconque des revendications 1 à 6, selon lequel on forme la boule (7) par fusion, mise en oeuvre au moyen d'une décharge en arc, d'une flamme d'hydrogène, d'un arc de plasma ou d'un faisceau laser.

9. Procédé selon la revendication 8, selon lequel la boule (7) est formée par une décharge en arc, la durée de la décharge en arc étant commandée par le déplacement d'une électrode produisant l'arc.

10. Procédé selon la revendication 8 ou 9, selon lequel on forme la boule au moyen d'une décharge en arc qui est formée par un courant pulsé formé par des impulsions positives et/ou des impulsions négatives.

11. Procédé selon la revendication 7, selon lequel l'atmosphère non oxydante contient 5 à 15% en volume d'hydrogène.

12. Procédé selon l'une quelconque des revendications précédentes, selon lequel on réunit le fil audit élément semiconducteur et audit cadre de montage au moyen d'une liaison par ultrasons.

## FIG. 1

## FIG. 2

## FIG. 3(a)

## FIG. 3(b)

## FIG. 4

## FIG. 5

CONSTRICTION    ECCENTRICITY

CONSTRICTION

0

CONSTRICTION

ECCENTRICITY

OCCURENCE OF ECCENTRICITY AND CONSTRICTION (%)

| WIRE | Aℓ | Cu | Aℓ | Cu |
|---|---|---|---|---|
| ANNEAL | NO | | ANNEALED | |